# EUROPEAN PATENT SPECIFICATION

(11) **EP 2 673 803 B1**
(45) Date of publication and mention of the grant of the patent: **14.04.2021**
(21) Application number: 12702294.5
(22) Date of filing: 08.02.2012
(51) Int. Cl.: H01L 23/62, H01L 25/07, H01L 21/60, H01L 23/42, H01L 23/492, H01L 23/00, H01L 23/24

(54) **POWER SEMICONDUCTOR MODULE AND METHOD TO PRODUCE A POWER SEMICONDUCTOR MODULE**
LEISTUNGSHALBLEITERMODUL UND HERSTELLUNGSVERFAHREN EINES LEISTUNGSHALBLEITERMODULS
MODULE SEMI-CONDUCTEUR DE PUISSANCE ET PROCÉDÉ DE FABRICATION D'UN MODULE SEMI-CONDUCTEUR DE PUISSANCE

(30) Priority: 08.02.2011 EP 11153689; 08.02.2011 EP 11153691; 27.05.2011 EP 11167810
(43) Date of publication of application: 18.12.2013
(73) Proprietor: ABB Power Grids Switzerland AG, 5400 Baden (CH)
(72) Inventor: KICIN, Slavo, CH-8049 Zürich (CH); SCHULZ, Nicola, CH-5300 Turgi (CH); HÄFNER, Jürgen, S-77142 Ludvika (SE); LIU, Chunlei, CH-5452 Oberrohrdorf (CH); HAMIDI, Amina, CH-5300 Turgi (CH); FABIAN, Jan-Henning, CH-5507 Mellingen (CH)
(74) Representative: Michalski Hüttermann & Partner Patentanwälte mbB
(86) International application number: PCT/EP2012/052118
(87) International publication number: WO 2012/107482

(56) References cited:
- EP-A1- 1 246 242
- EP-A1- 1 282 170
- GB-A- 897 077
- GB-A- 959 608
- US-A- 3 877 061
- US-A1- 2009 039 516
- US-B2- 7 538 436

## Description

### Technical Field

The invention relates to the area of high power applications, and in particularly to a power semiconductor module, an electronic power apparatus, and a method of manufacturing a power semiconductor module.

### Background Art

An electronic power apparatus comprises one or more (high) power semiconductor modules which may be connected in series or in parallel to one another. Usually, power semiconductor chips of the power semiconductor module may comprise switching functionality, and may be configured as transistors or diodes. Failure of one or more of the power semiconductor chips and thus of the power semiconductor modules during operation may cause a failure of the electronic power apparatus and also represent an important issue regarding manufacturing, maintenance and/or retrofitting applications.

For example, power semiconductor modules (particularly semiconductor modules such as insulated gate bipolar transistor (IGBT) modules) with an internal short circuit failure mode SCFM capability are important components of an electronic power apparatuses such as voltage source converters (VSC) usable in a power transmission area. SCFM capability means that a power semiconductor chip of the power semiconductor module fails not with an open circuit, but a short circuit. If failed, the power semiconductor chips are not able to switch any more. However, the power semiconductor chip still carry a load current at least for certain time. There is designed redundancy in the system, and the other power semiconductor modules are able to share the blocking voltage since a failed power semiconductor module has now only a function of a resistor (with a very low resistance) or conductor. Therefore, the electronic power apparatuses equipped with such power semiconductor modules usually require only regular, planned maintenance to change the failed power semiconductor modules.

One of the possible solutions (and a current solution of the applicant) for the SCFM capability of a power semiconductor module is based on melting of materials due to dissipation of energy induced by the failure. A silicon power semiconductor chip and a suitable metal part attached to an emitter contact of the power semiconductor chip (for example, aluminum (Al), silver (Ag) - these materials must create an eutectic alloy with silicon with sufficiently low melting temperature) melt and create an electrically highly conductive alloy - a so called "hot spot". Such a built-in solution has been applied in press-pack power semiconductor module concepts - a so called StakPak (see for example, EP 0 989 611 A2 or B1, US 6,426,561 B1, US 7,538,436 B2 the content of which will be detailed later). The collector side of the power semiconductor chips is soldered to the substrate. For example, an aluminum piece (a component to be melt to form a conductive channel through the chip) and the molybdenum piece (a component compensating a coefficient of thermal expansion (CTE) mismatch) are stacked on the emitter side of each power semiconductor chip. A mechanical component (a spring) is used to apply pressure necessary for a dry contact of a good quality. Here, the term "dry contact" may particularly denote a pressure based contact interface between the power semiconductor chip and components arranged adjacent to the power semiconductor chip. The spring concept also protects chips against mechanical damage allowing homogeneous distribution of pressure between power semiconductor chips and allows compensating height changes caused by short circuit failure.

S. Gunturi et al., "Innovative Metal System for IGBT Press Packs", presented at ISPSD 2003, describes a spring-loaded press pack package comprising SCFM capability. A respective package comprises a baseplate on which a silicon-based power semiconductor chip is soldered. A platelet is arranged on an upper side of the silicon chip, and is pressed by a spring loaded pin towards the power semiconductor chip. In case of an electronic failure, the material of the power semiconductor chip and the material of the platelet are heated such that an eutectic metallic alloy is formed which provides a short circuit path over the power semiconductor chip.

EP 0 989 611 A2 or B1 or US 6,426,561 B1 describes a pressure-based IGBT module comprising a plurality of power semiconductor chips connected in parallel to one another and being sandwiched between a conductive substrate and respective pistons. A layer made of a material such as aluminum, silver, gold, copper, or magnesium is arranged in contact with the power semiconductor chip, and is arranged between the substrate and a respective one of the pistons. Upon heating, the layer together with the semiconductor material of the power semiconductor chip form an eutectic mixture, and thus form a metallically conductive channel over the power semiconductor chip.

US 7,538,436 B2 describes a high-power press-pack semiconductor module comprising a plurality of power semiconductor chips sandwiched between a conductive base plate and a conductive top plate. A contact piston presses the top plate and a respective one of the power semiconductor chips against the base plate. The material of the top plate and the base plate is made of a metal matrix composite material whose value of a coefficient of thermal expansion is adaptable to a value either close to or matching a value of the coefficient of thermal expansion of the material of the power semiconductor chip.

From EP 1 246 242 A1 a power semiconductor module is known that comprises a housing containing a substrate, a contact stamp, and a semiconductor chip with two main electrodes. An electrically conducting layer is provided between the first main electrode and the substrate or between the second main electrode and the contact stamp. The layer is formed from a bundle of straight and essentially parallel wires. The layer contains a material which fuses the material of the semiconductor chip together to form a eutectic. Preferred Features: The semiconductor chip is made of silicon and the layer contains aluminum, gold, silver, copper or magnesium or a compound of the above. The melting point of the compound consisting of silicon and the layer material lies below 900 degrees C.

GB 897 077 A describes that a silver foil is soldered to a molybdenum plate by means of a soldering foil comprising a copper-silver eutectic with 4% nickel and 4% manganese added thereto. The soldering is carried out at 850 DEG C. and forms part of a manufacturing process for a semiconductor device.

From US 2009/039516 A1 a power semiconductor component having a basic body and at least one contact area is known. At least one first thin metallic layer of a first material is arranged on the contact area. A second metallic layer-thicker than the first-of a second material is arranged on the first material by a pressure sintering connection of said material. The associated method has the following steps: producing a plurality of power semiconductor components in a wafer; applying at least one first thin metallic layer on at least one contact area of a respective power semiconductor component; arranging a pasty layer, composed of the second material and a solvent, on at least one of the first metallic layers for each power semiconductor component; pressurizing the pasty layer; and singulating the semiconductor components.

EP 1 282 170 A1 describes a device which has a semiconducting chip of a first material and at least one melting element containing a second material as an alloy partner, whereby an alloy, especially a eutectic, is formed between the first and second materials. The device has at least one burn-off element containing at least one first high-energy material that can be caused to perform an exothermal reaction by introducing activation energy.

Typical problems relevant for the described device or StakPak module are aging of dry electrical contacts (for example, due to a penetration of silicone gel which may cover the power semiconductor chips), a resistance of a current path ((particularly owing to) many interfaces (particularly between respective components)), a complexity of (particularly an arrangement of the) mechanical components, a limitation of current load by the spring shape, and costs. Recently there has been also started a discussion about possible limits of current and voltage rating in the future.

### Summary of invention

It is an object of the present invention to provide a power semiconductor module or device and an electronic power apparatus having improved characteristics. Further, it is an object of the present invention to provide a method of manufacturing such a power semiconductor module and such an electronic power apparatus.

This object is addressed by the independent claims. Preferred embodiments are described in the dependent claims. According to an aspect of the invention, a power semiconductor module is provided, the power semiconductor module comprises a bottom electrode-baseplate, wherein the bottom electrode-baseplate is electrically and thermally conductive, a top electrode-baseplate, wherein the top electrode-baseplate is electrically and thermally conductive, a power semiconductor chip, and a first preform, wherein the power semiconductor chip comprises a bottom electrode and a top electrode, the first preform is made of material configured for supporting a creation of an electrically conductive alloy when being melted, the first preform provides in combination with the power semiconductor chip a short circuit failure mode capability of the power semiconductor module, and wherein the bottom electrode of the power semiconductor chip is thermally and electrically connected to the bottom electrode-baseplate via a first bonding layer, and wherein the top electrode of the power semiconductor chip is thermally and electrically connected to a first side of the first preform via a second bonding layer. According to the invention, the second side of the first preform is thermally and electrically connected to the top electrode-baseplate via a third bonding layer.

According to another exemplary aspect of the invention, an electronic power apparatus is provided, the electronic power apparatus comprising a power semiconductor module as described above.

According to another exemplary aspect of the invention, a method of manufacturing a power semiconductor module is provided, the method comprising providing a power semiconductor chip comprising a bottom electrode and a top electrode, providing a bottom electrode-baseplate, wherein the bottom electrode-baseplate is electrically and thermally conductive, providing a top electrode-baseplate, wherein the top electrode-baseplate is electrically and thermally conductive, providing a first preform made of material configured for supporting a creation of an electrically conductive alloy (particularly with a material of the semiconductor chip) when being melted, preparing a subassembly of the bottom electrode-baseplate, the power semiconductor chip, and the first preform by bonding (particularly by sintering), and bonding the top electrode-baseplate to the subassembly (particularly by soldering).

In the context of the present application, the term "power semiconductor module" may particularly denote an arrangement which may comprise at least one power semiconductor based component, for example a diode or a transistor.

The term "power semiconductor chip" may particularly denote a semiconductor material based functional component. For example, such a functionality may refer to switching a current.

The term "preform" may particularly denote a parison or a workpiece which may particularly comprise or be configured as a platelet.

The terms "top and bottom elements" and "upper and lower sides" may particularly denote a relative arrangement of first and second elements or of first and second sides to one another, and may not imply any direction or any arrangement relative to a ground level.

The term "side" of an element may particularly denote a (two dimensional) surface or (three dimensional) surface layer portion of the element.

The term "a first element is connected to a second element via a third element" may refer to a direct or indirect connection (particularly via further elements) between the first, second, and third elements.

The term "bonding" may particularly denote a technique for joining elements to one another, and may particularly comprise sintering, soldering, brazing, and diffusion bonding.

The terms detailed in the section "Background Art" may particularly apply to a description of the present invention.

The terms "element" and "component" may be used in an exchangeable way.

Accordingly, the power semiconductor module may comprise a high reliability under normal operation conditions particularly in comparison to pressure based semiconductor devices. In particular, a presence of dry contacts in the power semiconductor module may be eliminated by present invention, in particular by the bonding layers between the individual elements. Further, a risk of a cover material (for example, silicone gel) penetrating into interfaces between respective components and/or a risk of oxidation of the interface between the respective components, particularly by forming insulating layers comprising oxygen, may be reduced.

Further, electric interfaces between the respective components of the power semiconductor module may be reduced, thereby reducing a resistance along a current path between the top and bottom electrode-baseplates. Accordingly, an efficiency of the power semiconductor module and thus the electronic power apparatus may be enhanced.

Further, a mechanical complexity of the power semiconductor module may be reduced by avoiding a constructive design comprising a pressure applying element such as a spring.

Further, the power semiconductor module and the electronic power apparatus may accordingly comprise a reduced package volume, particularly a reduced height (particularly by about two thirds in comparison to pressure based power semiconductor modules), as compared to pressure-based power semiconductor modules and electronic power apparatuses, respectively. Accordingly, the power semiconductor module and the electronic power apparatus may be used in various applications areas.

Further, by manufacturing the power semiconductor module based on bonding layers instead of based on the pressure applying elements such as a spring, manufacturing costs of the power semiconductor module may be reduced.

Further, a limitation of a current load along the power semiconductor module caused by a shape of the spring of the pressure-based power semiconductor module may be avoided.

Further, since the bonding layers may represent thin elements and may directly contact adjacent layers or components, the power semiconductor module may comprise an improved heat dissipation in comparison to power semiconductor module based on pressure applying elements such as a spring. In particular, the improved heat dissipation of the power semiconductor module via its bottom-electrode baseplate and top electrode-baseplate may correspond to an improved inherent cooling capability of the power semiconductor module being sufficient for short time heat pulses.

Further, the power semiconductor module may comprise an improved internal SCFM capability provided by the first preform in combination with the power semiconductor chip. In case of a failure of the power semiconductor chip (for example in case of a voltage or current spike through the power semiconductor chip) the material of the first preform and the material of the power semiconductor chip may be heated to melt such that a conductive alloy (particularly an eutectic alloy) having a lower melting temperature compared to the material of the first preform and the material of the power semiconductor chip, may be formed. Accordingly, a conductive current path may be formed by the melted material of the first preform and the material of the melted power semiconductor chip such that the power semiconductor chip may fall into a short circuit failure mode. The failed power semiconductor chip may not have a functionality of a switch or diode any more. However, a permanent conductive path with sufficient current carrying capability may be formed by the conductive alloy such that, owing to redundancy in the system in terms of another power semiconductor chips, the respective electronic apparatus may be still operational at least for a short time. Accordingly, the lifetime of the electronic power apparatus may be prolonged despite a failure of the power semiconductor chips by providing a short circuit failure mode. Further, during this short circuit failure mode maintenance measures may be initiated by for example, a control unit of the electronic power apparatus.

To provide the short circuit failure mode capability, the first preform must provide enough material to form the conductive channel though the failed power semiconductor chip. This may be the case if the thickness of the first preform is at least 50% of the thickness of the power semiconductor chip and/or may have a thickness of at least 0.1mm, more preferable of at least 0.5mm and most preferably of at least 0.8mm.

Accordingly, all issues mentioned in the section "Background Art" may be addressed by the power semiconductor module, the electronic power apparatus and the method of manufacturing a power semiconductor module according to the independent claims.

Next, further exemplary embodiments of the power semiconductor module will be explained. However, these embodiments also apply to the electronic power apparatus, and the method of manufacturing a power semiconductor module.

According to the exemplary aspects of the invention, the manufactured semiconductor module may comprise a sandwiched stack formed by the bottom electrode-baseplate, the semiconductor chip, the first preform, and the top electrode-baseplate. Each component of the power semiconductor module may be connected to one another by respective bonding layers formed by bonding (particularly by sintering or soldering).

According to the exemplary aspect of the invention, the stack comprising the power semiconductor chip and the first preform and may be further elements is formed. All the elements of the sack, including the semiconductor chip and the first preform, are thermally and electrically connected to each other via bonding layers, in particular by the third bonding layer, and a bottom element in the stack being connected to the bottom electrode-baseplate by the first bonding layer and the top element in the stack being connected to the top electrode-baseplate by the second bonding layer.

The power semiconductor module may further comprise a second preform comprising material being configured for compensating a thermal expansion mismatch between the power semiconductor chip and the first preform, wherein the second side of the first preform may be thermally and electrically connected to a first side of the second preform via a fourth bonding layer, wherein the second side of the second preform may be thermally and electrically connected to the top electrode-baseplate via the third bonding layer. In particular, the arrangement of the second preform may reduce stress between the material of the power semiconductor chip and the material of the first preform, thereby improving a reliability of the semiconductor device.

According to a further aspect of the invention, the stack may comprise the second preform, wherein the second side of the first preform is thermally and electrically connected to the first side of the second preform via the fourth bonding layer. In this case, the top element in the stack is formed by the second preform and top element of the stack is thermally and electrically connected to the top electrode-baseplate via the third bonding layer.

At least one of the first and second bonding layers may be configured as silver layers such that conventional and cheap material may be used for connecting the power semiconductor chip to the bottom electrode-baseplate. Further, low melting temperature alloys may be formed by a silver bonding layer in combination with the material of the semiconductor chip (particularly silicon). Thus, the SCFM capability of the semiconductor device may be improved.

The third bonding layer is configured as a layer of solder, whereby the top electrode-baseplate and the first preform are connected to one another by means of soldering. Thus, a cost-effective technique for connecting the respective components of the power semiconductor module to one another in a mechanically stable way is used, thereby facilitating the manufacturing of the power semiconductor module.

The fourth bonding layer may be configured as a silver layer, and the third bonding layer may be configured as a layer of solder. Accordingly, in a case in which the second preform may be present in the power semiconductor module, the first and second preforms may be connected to one another via a silver layer and the second preform and the top electrode-baseplate may be connected to one another by a layer of solder. Accordingly, a mechanical stability of the power semiconductor module and the SCFM capability of the power semiconductor module may be further enhanced by using silver and solder as bonding material, as may be explained above.

The power semiconductor module may comprise at least two stacks in parallel. This has the advantage, that the current load can be distributed. Further, in case the third bonding layer is formed by solder, a difference of the height between the stacks can easily be compensated.

The power semiconductor chip may be an insulated gate bipolar transistor (IGBT), a diode, a metal oxide semiconductor field effect transistor (MOSFET), a thyristor, a gate turn off (GTO) thyristor, an integrated gate commutated thyristor (IGCT), or a reverse conductive chip. Here, the term "reverse conductive chip" may particularly denote a power semiconductor chip configured for operating in both freewheeling diode mode and transistor mode by utilizing the same available silicon volume in both modes such that an increase in the power density level of the power semiconductor chip and thus in the module may be accomplished. For example, a reverse conductive chip may comprise or may be configured as a bimodal insulated gate transistor (BIGT) or a reverse conductive IGBT.

The top electrode-baseplate and/or the bottom electrode-baseplate may be made of molybdenum, aluminum-graphite, copper-graphite, copper-molybdenum or any material having a coefficient of thermal expansion sufficiently close to the coefficient of thermal expansion of a power semiconductor chip material (for example, silicon). Thus, a mechanical stability of the power semiconductor module may be further increased, since stress during heating of the electrode-baseplates and the power semiconductor chip may be reduced and the latter components may not "move" relative to one another.

Further, the top electrode-baseplate may be arranged in parallel to the bottom electrode-baseplate.

The first preform may be made of aluminum-graphite (Al-graphite) or a laminate material of aluminum and molybdenum-aluminum (for example, AI/AI(AIMo)/AI). In particular, in the latter case, layers of aluminum and molybdenum-aluminum may be stacked onto one another, and/or may be sandwiched between the power semiconductor chip and the top electrode-baseplate. In particular, aluminium may form a conductive alloy, particularly an eutectic alloy, in combination with the bulk material of the semiconductor device (for example, silicon). In particular, molybdenum may further comprise a coefficient of thermal expansion of about 5 ppm/K which may be close compared to the coefficient of thermal expansion of silicon (3 ppm/K) such that the mechanical stability of the power semiconductor module may be improved. Further, the first preform may have a thickness which is at least 50% of the thickness of the power semiconductor chip and/or may have a thickness of at least 0.1mm, more preferable of at least 0.5mm and most preferably of at least 0.8mm.

The first preform may be made of aluminium, silver, gold, copper and/or magnesium, and the second preform may be made of aluminum-graphite, copper-graphite, copper-molybdenum or molybdenum (particularly having a coefficient of thermal expansion between 3 to 8 ppm/K). In addition to the above described technical effects, these materials may represent cost-effective and easily processible materials when designing the first and second preforms. Further, the first preform may have a thickness which is at least 50% of the thickness of the power semiconductor chip and/or may have a thickness of at least 0.1mm, more preferable of at least 0.5mm and most preferably of at least 0.8mm.

In particular, in a case, in which the first preform comprises aluminium-graphite, the aluminium-graphite may comprise an aluminium skin or outer surface portion of the first (bulk) preform which may increase an amount of aluminium of the alloy formed when heat impacts the first preform in a failure event. Accordingly, the alloy formed by the first preform and the power semiconductor chip may be further improved.

An aluminium foil may be arranged between the bottom electrode-baseplate and the bottom electrode of the power semiconductor chip, which may allow for providing additional aluminium from a bottom side of the power semiconductor chip for the creation of the conductive alloy. Thus, the conductive path over or through the semiconductor chip may be improved, thereby further improving a short circuit failure mode of the power semiconductor module.

In particular, a lower side of the aluminium foil may be connected to the bottom electrode-baseplate via a ((silver) sintered) bonding layer, and the upper side of the aluminium foil may be connected to the bottom electrode of the power semiconductor chip by another ((silver) sintered) bonding layer. Accordingly, manufacturing of the power semiconductor module may be facilitated in that a conventional connection technique may be used for connecting various components of the power semiconductor module to one another. In particular, in a case in which all bonding layers or all bonding layers expect the third bonding layer may be realized by sintering, the method may be further facilitated in that one common connection technique may be employed for these layers.

According to a preferred embodiment, the aluminium foil is a inherent part of the bottom electrode-baseplate so that the surface of the bottom electrode-baseplate towards the stack or towards the power semiconductor chip is formed by the aluminium foil.

The power semiconductor chip may be embedded in silicone gel. This silicone gel may provide a protection of the power semiconductor chip against its environment and may provide an electrical insulation of the power semiconductor chip. In particular, the silicone gel may fill up open spaces of a housing of the power semiconductor module.

In particular, the power semiconductor module may comprise a package casing or package housing which may withstand the failure event and the formation of the alloy as described above, since temperature caused by the failure event and impacting the power semiconductor module may be dissipated over the housing to the environment. In particular, the package may also be configured for withstanding an overpressure which may develop in the power semiconductor module owing to the failure event of the power semiconductor chip.

The bottom electrode-baseplate and/or the top electrode-baseplate may be configured for being cooled (particularly by a water cooling system or an air cooling system) such that a double-side cooled power semiconductor module comprising SCFM capability may be provided. Accordingly, a higher switching power per power semiconductor chip material area may be provided owing to the cooling of the top electrode-baseplate and the bottom-electrode base plate. Further, a number of used power semiconductor modules in the electronic power apparatus may be reduced. Further, since the power semiconductor chip may be connected to the top and bottom electrode-baseplates by bonding, the semiconductor chip may be connected to two large thermal masses such that heat pulses may be effectively buffered by thermal capacitances of the top and bottom electrode-baseplates. Accordingly, a cooling system connected to the top and bottom electrode-baseplates may be designed in a less efficient way, thereby further reducing costs.

In particular, the bottom electrode-baseplate, the top electrode-baseplate, the power semiconductor chip, the first preform and/or the second preform may comprise a surface layer which may be, for example, formed by electroplating and may serve for protecting a surface of the respective component against damages and/or to reduce electrical resistance. Accordingly, a respective bonding layer is formed between the surface layer of the component and an adjacent component.

In particular, the power semiconductor module may further comprise an at least another power semiconductor chip (or a plurality of another power semiconductor chips) which is (or are) connected to the bottom electrode-baseplate and the top electrode-baseplate in a similar way as described above with respect the power semiconductor chip. In particular, one or more of the above described measures and technical effects may apply to such a power semiconductor module.

In particular, the power semiconductor chips of one or more of the power semiconductor modules may be connected in parallel to one another.

Next, further exemplary embodiments of the electronic power apparatus will be explained. However, these embodiments also apply to the power semiconductor module and the method of manufacturing a power semiconductor module.

In particular, the electronic power apparatus may comprise a plurality of power semiconductor modules each of which comprising one or more power semiconductor chips. The power semiconductor chips of one or of more power semiconductor modules may be connected in parallel to one another, and the power semiconductor modules may be connected in series to one another. Accordingly, in a case of a failure of one of the power semiconductor chips of one of the power semiconductor modules, the other power semiconductor modules may provide a current switching or current blocking capability of the electronic power apparatus.

In particular, the power semiconductor modules may be stacked above one another such that the electronic power apparatus may comprise a compact design.

The electronic power apparatus may be configured as a direct current (DC) circuit breaker apparatus. Accordingly, by designing the power semiconductor modules of the DC circuit breaker apparatus with a SCFM capability, the DC circuit breaker apparatus may be operable despite a failure event of one of its power semiconductor modules. In particular, since the power semiconductor module may represent a large amount of the manufacturing costs of the DC circuit breaker apparatus, reducing the manufacturing costs of the DC circuit breaker apparatus by about more than 50 per cent in comparison to a DC circuit breaker apparatus comprising pressure based power semiconductor modules may be accomplished. Further, in a case of an electronic power apparatus comprising a plurality of power semiconductor modules (for example, 100 semiconductor modules) being connected in series to one another and being stacked, the reduced height of the power semiconductor modules (in comparison to the pressure based power semiconductor modules) may cause the electronic power apparatus to comprise a compact shape.

In particular, in a case in which the DC breaker circuit apparatus may comprise BIGTs, the DC breaker apparatus may be usable in High Voltage DC (HVDC) transmission networks. In particular, a lifetime of the short circuit failure mode of the DC circuit breaker apparatus may be sufficiently long even being shorter in comparison to a lifetime of a short circuit failure mode of a pressure based power semiconductor module or electronic power apparatus.

In particular, the electronic power apparatus may comprise a bypassing functionality configured for bypassing a failed power semiconductor module and thus may provide another short circuit failure mode functionality of the electronic power apparatus, thereby prolonging the lifetime of a failed power semiconductor module and the respective short circuit failure mode of the electronic power apparatus. This functionality may be executed timely parallel with respect to the short circuit failure mode of the failed power semiconductor module. In particular, the bypassing functionality may comprise a switching unit being electrically connected in parallel to power semiconductor module of the electronic power apparatus or in parallel to the electronic power apparatus. Thus, the switching unit may either form part of the electronic power apparatus or may be embodied as a separate unit. In particular, the switching unit may be mechanically operated using, for example, hydraulically generated pressure, or may be electrically operated. In case of an electrically operated switching unit, the switching unit may be embodied as a controllable relay.

In particular, in a case in which the electronic power apparatus may comprise power semiconductor modules comprising power semiconductor chips in the form of transistors, the bypassing functionality may comprise a driving gate unit configured for permanently switching on the another power semiconductor chips distinct of the failed power semiconductor chip such that a current may be distributed along all power semiconductor chips instead of only along the failed power semiconductor chip. Thus, a lifetime of the failed power semiconductor module may be prolonged. The latter described bypassing functionality may similarly apply to power semiconductor modules comprising diodes.

Next, further exemplary embodiments of the method of manufacturing a power semiconductor module will be explained. However, these embodiments also apply to the power semiconductor modules and the electronic power apparatus.

The method may further comprise providing a second preform made of material being configured for compensating a thermal expansion mismatch between the power semiconductor chip and the first preform, and bonding (particularly sintering) the second preform to the subassembly. Accordingly, this measure and the accordingly manufactured power semiconductor module may comprise the above described technical effects and advantages.

In particular, an aluminum foil may be connected to the bottom electrode-baseplate and the semiconductor chip by bonding, particularly by (silver) sintering.

In particular, the sintering may comprise low temperature bonding (LTB) or nanosintering, thereby facilitating the method by using conventional bonding techniques.

In particular, the bottom electrode-baseplate, the power semiconductor chip, and the first preform may be bonded, particularly sintered, to one another in one step particularly using a respective fixture tool. Thus, the manufacturing process may be speeded up.

In particular, the first and/or second preforms may be bonded, particularly sintered, to the power semiconductor chip, and afterwards the power semiconductor chip including the first and/or second preforms may be bonded, particularly sintered, to the bottom electrode-baseplate. Accordingly, a relative arrangement of the fragile power semiconductor chip and the first and/or second preforms may be firstly set before connecting the power semiconductor chip to the bottom electrode-baseplate.

In particular, the first and/or second preforms may be bonded, particularly sintered, to one another, and afterwards to the power semiconductor chip particularly using a subsequent bonding step, particularly sintering step, whereby contamination of the power semiconductor chip edges may be prevented which may occur when bonding, particularly sintering, the combined first and second preforms to the power semiconductor chip.

In particular, a sequence of bonding the bottom electrode-baseplate, the power semiconductor chip, the first preform, the second preform, and/or the aluminium foil to one another may be arbitrarily.

In particular, the sintered bonding layers between the respective components of the power semiconductor module may be configured for being withstanding short circuit events in that a degree of strength of the sintered bonding layers between the respective components of the power semiconductor module may be sufficiently strong.

In particular, the power semiconductor module may be configured for withstanding a transition event during which a short circuit may propagate from one power semiconductor chip to another power semiconductor chip. In a case in which the power semiconductor module may comprise at least two power semiconductor chips, the short circuit may propagate within the failed power semiconductor module and eventually may move to another power semiconductor module of the electronic power apparatus.

In particular, since the power semiconductor module may comprise a compact shape, cooling of the power semiconductor chips may be improved, thereby reducing the heat impact on the power semiconductor module during the operation and supporting to prevent failure events.

Further aspects of the invention may be given by the dependent claims.

### Brief description of drawings

The invention will be described in more detail hereinafter with reference to examples of embodiment, but to which the invention is not limited.
Figures 1 to 4 show perspective views of steps of a method of manufacturing a power semiconductor module according to an exemplary embodiment of the invention.
Figure 5 shows a schematic cross-sectional view of an embodiment of the power semiconductor module, which may be used in a electronic power apparatus according to an exemplary embodiment of the invention.
Figure 6 shows an enlarged view of a power semiconductor module of Figure 5.
Figure 7 shows a power semiconductor module of a DC circuit breaker apparatus according to another exemplary embodiment of the invention.

### Description of embodiments

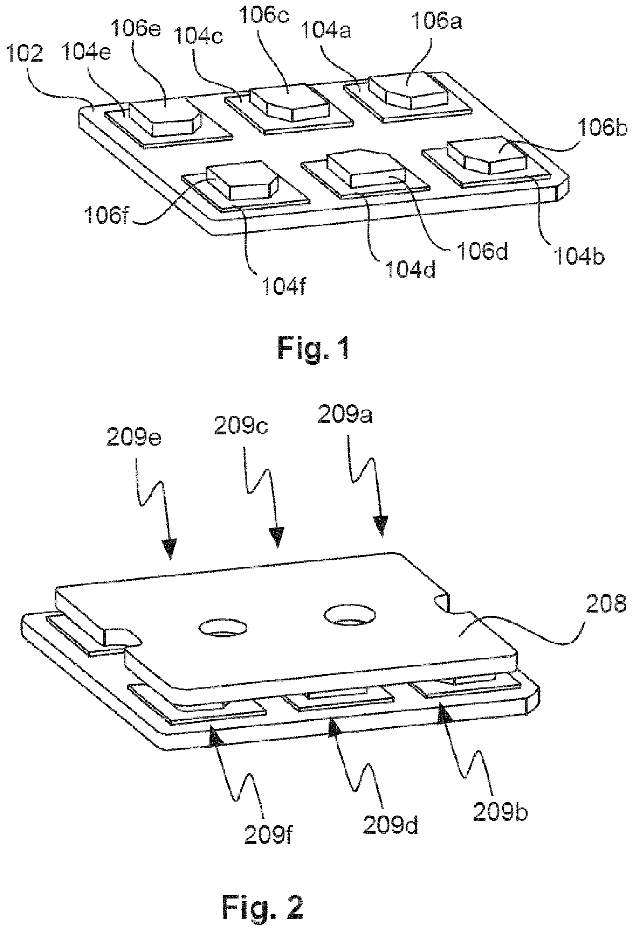

Referring to Figures 1 to 4, a method of manufacturing a power semiconductor module of an electronic power apparatus according to an exemplary embodiment of the invention will be explained. The electronic power apparatus is usable in high power applications, and is configured for withstanding heat impacted failure of one of its power semiconductor chips such that an operation of the electronic power apparatus is maintained despite of the failure of the one of its power semiconductor modules.

In a first step of the method, a bottom electrode-baseplate 102, a plurality of power semiconductor chips 104a-f, and a plurality of preforms 106a-f are provided. The bottom electrode-baseplate 102 is made of copper-molybdenum. A part of the power semiconductor chips 104a-f of the plurality of power semiconductor chips 104a-f are configured as switching components in the form of silicone based IGBTs and another part of the power semiconductor chips 104a-f of the plurality of power semiconductor chips 104a-f are configured as free-wheeling diodes. It is also possible that all the semiconductor chips 104a-f are of the same type. Further, each first preform 106a-f of the plurality of first preforms 106a-f are identically designed with respect to one another, and are made of aluminium-graphite.

The thickness of the first preform may have at least 50% of the thickness of the power semiconductor chip 104a-f and/or may have a thickness of at least 0.1mm, more preferable of at least 0.5mm and most preferably of at least 0.8mm. Actually, the thickness of the first preform 106a-f depends on the thickness of the power semiconductor chip 104a-f, which again depends on the electric specification, i.e. on the blocking voltage of the power semiconductor chip 104a-f. As described above, the first preform must provide enough materiel to form a conductive channel if the chip fails.

A bottom electrode of each of the power semiconductor chips 104a-f of the plurality of semiconductor chips 104a-f is bonded to a respective upper side of the bottom electrode-baseplate 102 using a silver sintering process. Accordingly, a first silver bonding layer is formed between the upper side of portions of the bottom electrode-baseplate 102 and the respective lower electrode of each of the power semiconductor chips 104a-f. Next, an upper electrode of each of the power semiconductor chips 104a-f is sintered to a lower side of a respective one of the preforms 106a-f. A used sinter material is made of silver. Accordingly, a second silver bonding layer is formed between the upper electrode of the power semiconductor chips 104a-f and the lower side of the preforms 106a-f.

Next, in a subsequent method step illustrated in Figure 2, a top electrode-baseplate 108 made of copper-graphite is soldered to the upper sides of the preforms 106a-f such that a third soldered bonding layer is formed between each of the preforms 106a-f and respective portion of the top electrode-baseplate 208.

Accordingly, stacks 209a-f are formed each of which comprising a single power semiconductor chip 104a-f and one of the first preforms 106a-f. Within each stack 209a-f the power semiconductor chip 104a-f is bonded to the preform106a-f. The power semiconductor module thus comprises the bottom electrode-baseplate 102 bonded to the bottom element within the stack 209a-f. In the present embodiment, the bottom element within the stack 209a-f is the power semiconductor chip104a-f. The top element within the stack 209a-f is bonded to the top electrode-baseplate 108. In the present embodiment, the top element is the preform 106a-f.

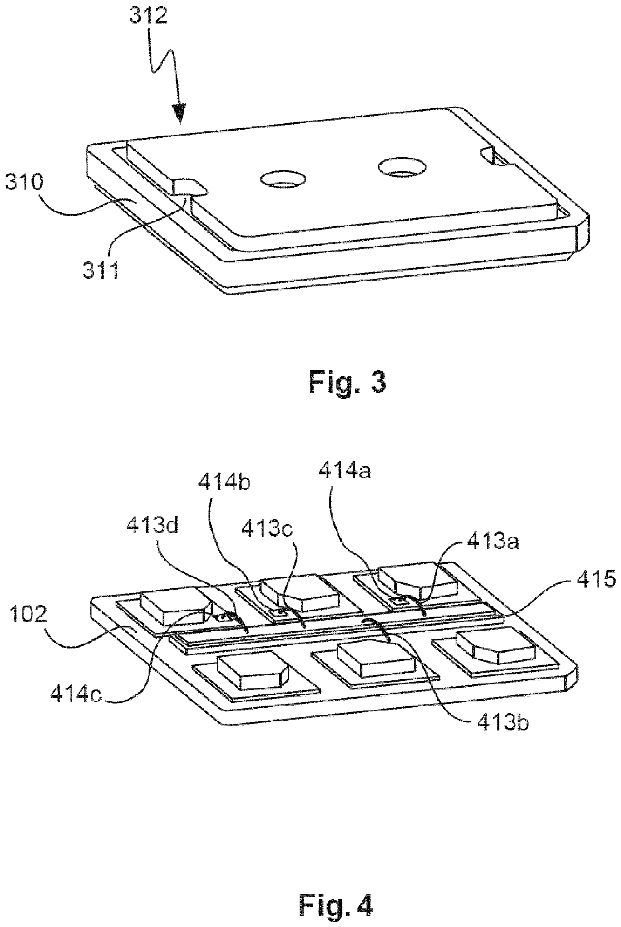

Next, in a subsequent method step illustrated in Figure 3, a rectangularly shaped, framed housing 310 is attached to the circumference of the upper surface of the bottom electrode-baseplate 102. An upper inner surface portion of an inner surface of the housing 310 abuts against lateral sides of the top electrode-baseplate 208. Further, silicone gel 311 is inserted in a space formed between the bottom electrode-baseplate 102, the top electrode-baseplate 208 and the housing 310 such that the semiconductor chips 106a-f are embedded in the silicone gel 311.

Next, a plurality of the above described power semiconductor modules comprising the stacks 209a-f arranged in the housing 310 and covered by the silicone gel 311 are manufactured and are stacked above one another. The stacks of one power semiconductor module are connected in parallel to one another, and the plurality of power semiconductor modules are connected in series to one another. Thus, the electronic power apparatus, now referenced by a reference numeral 312, is manufactured.

Figure 4 shows an intermediate method step which is executed between the method step illustrated in Figure 1 and the method step illustrated in Figure 2. Here, respective bonding wires 413a-d are attached to gate contacts 414a-c of the power semiconductor chips 106a, c, d, e and to a conductive lead 415 which is arranged along a longitudinal extension of the bottom electrode-baseplate 102 between the power semiconductor chips 106a, c, e and the power semiconductor chips 106b, d, f. The conductive lead 415 forms part of an electrical connection to the gate contacts 414a-c of the power semiconductor chips 104a-f from auxiliary terminals used for a control of the power semiconductor chips. It is noted that the auxiliary terminals are not shown in Figure 4. Although only four bonding wires 413a-d are shown in Figure 4 for illustration purposes, a suitable number of bonding wires are attached to the respective gate contacts of the power semiconductor chips 104a-f such that the power semiconductor chips 104a-f of the assembled power electronic module and/or electronic power apparatus 312 are electrically connected in parallel to one another.

Further, the method may comprise a step of silver sintering an aluminium foil to the upper side of the bottom electrode-baseplate 102 prior to connecting the semiconductor chips 104a-f to the bottom electrode-baseplate 102. The aluminium foil may extend along an entire surface of the bottom electrode-baseplate 102, and may be present between connection regions of the semiconductor chips 104a-f to the bottom electrode-baseplate 102.

Prior to operation of the power electronic module and / or electronic power apparatus 312, the bottom and top electrode-baseplates 102, 208 are connected to a water cooling system such that the bottom electrode-baseplate 102 and the top electrode-baseplate 208 may be cooled, in order to improve the operation performance of the electronic power apparatus 312. Gate voltages are applied to respective gate contacts of the power semiconductor chips 104a-f of the power semiconductor module. Afterwards, electric current is applied to the bottom electrode-baseplate 102 such that a current is transferred to the top electrode-baseplate 208 via each of the stacks 209a-f comprising a power semiconductor chip.

In the following, a failure event of the power semiconductor module and/or electronic power apparatus 312 will be described. In such an incidence, one of the power semiconductor chips 104a-f is impacted by a heat impulse caused by, for example, a cosmic ray event or a flash-over between respective portions of the bottom electrode-baseplate 102 and the top electrode-baseplate 108. In the following, it is assumed for explanation purposes that the power semiconductor chip 104a is affected by such a heat impact and the power semiconductor chip 104a comprises an IGBT. The heat is transferred to the material of the preform 106a and the bulk material of the power semiconductor chip 104a such that an electrically conductive alloy or even eutectic alloy starts to form at an interface between the upper side of the power semiconductor chip 104a and the lower side of the preform 106a. A respective melting process results in an electrically conductive channel through the semiconductor chip 104a, whereby a stable short circuit failure mode of the semiconductor device 109a is caused. Accordingly, the failed power semiconductor chip 104a is permanently switched on such that a switching function of the electronic power apparatus 111 will be provided by the not affected power semiconductor chips of the other power semiconductor modules of the electronic power apparatus 312. Thus, a continuous operation of the electronic power device 312 is provided.

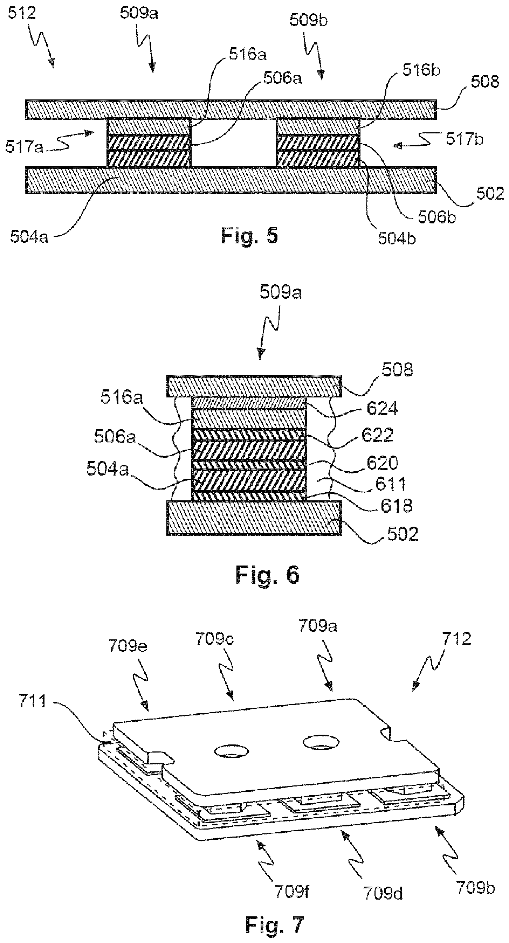

Referring to Figures 5 and 6, a power semiconductor module 512 according to another exemplary embodiment of the invention will be explained. Such power electronic modules can be stacked to form an electronic power apparatus.

The power semiconductor module 512 comprises a bottom electrode-baseplate 502 and a top electrode-baseplate 508 both made of molybdenum. A plurality of silicon based semiconductor chips 504a, b, a respective plurality of first preforms 506a, b made of aluminium and a plurality of second preforms 516a, b made of molybdenum are sandwiched between the bottom electrode-baseplate 502 and the top electrode-baseplate 508 and form respective stacks 517a, b between the bottom electrode-baseplate 502 and the top electrode-baseplate 508. A first silver bonding layer 618 is sintered between the bottom electrode-baseplate 502 and the lower electrode of the power semiconductor chip 504a (Figure 6). A second silver bonding layer 620 is sintered between the upper electrode of the power semiconductor chip 504a and the lower side of the first preform 506a. A third silver bonding layer 622 is sintered between the upper side of the first preform 506a and the lower side of the second preform 516a. Further, a layer 624 of solder is soldered between the upper side of the second preform 516a and the lower side of the top electrode-baseplate 508. Afterwards, the power semiconductor chips 509a, b are embedded in silicone gel 611.

In addition to the stacks 209a-f described with reference to Figures 1 to 4, the stack 509a comprises a further improved mechanical stability and reliability, since a coefficient of thermal expansion of the second preform 516a is close to a coefficient of thermal expansion of the silicon material of the power semiconductor chip 506a.

The thickness of the first preform 506a, 506b may have at least 50% of the thickness of the power semiconductor chip 104a-f and/or may have a thickness of at least 0.1mm, more preferable of at least 0.5mm and most preferably of at least 0.8mm. Actually, the thickness of the first preform 506a, 506b depends on the thickness of the power semiconductor chip 504a, 504b, which again depends on the electric specification, i.e. on the blocking voltage of the power semiconductor chip 504a, 504b. As described above, the first preform must provide enough materiel to form a conductive channel if the chip fails.

A respective method of manufacturing the power semiconductor module is described in the following. First, the bottom electrode-baseplate 502, the power semiconductor chips 504a, b, the first preforms 506a, b, and the second preforms 516a, b are stacked onto one another. The latter components are then sintered to one another in one sintering step using the silver sintering materials. Alternatively, the components are sintered to one another in subsequent sintering steps. Alternatively, the bottom electrode-baseplate 502 is sintered to the power semiconductor chips 509a, b, and afterwards, in one sintering step, the first and second preforms 506a, b, 516a, b are sintered to one another and to the power semiconductor chip 506a, b, respectively.

Referring to Figure 7, a power semiconductor module 712 with stacks 709a-f for a DC circuit breaker apparatus according to an exemplary embodiment of the invention is shown. The DC breaker apparatus comprises a mechanical disconnecting device, a small switching device, and a plurality of identically designed power semiconductor modules 712 each one which comprising the stacks 709a-f, preferably at least two stacks 709a-f in parallel in each power semiconductor module 217. The power semiconductor modules are stacked above one another and are connected in series to one another. The mechanical disconnecting device and the small switching device are arranged in series and in a bypass line bypassing the plurality of power semiconductor modules. The small switching device is identically constructed compared to the power semiconductor module with stacks 509a, b illustrated in Figures 5 and 6, and the stacks 709a-f are similarly constructed compared to the stacks 209a-f of the power semiconductor module 312 illustrated in Figures 1 to 4. However, the power semiconductor chips of the stacks 709a-f comprise BIGTs instead of the IGBTs which are embedded in silicone gel 711.

During operation of the DC circuit breaker apparatus, the top and bottom electrode-baseplates of the small switching device are cooled using an air cooling device, whereas top and bottom electrode-baseplates 702, 708 of the stacks 709a-f are not cooled. Current is transferred via the bypass line comprising the mechanical switching device and the small switching device. At an instance, the power semiconductor modules are controlled to switch the DC circuit breaker apparatus 712, and current is transferred via the power semiconductor modules and thus the stacks 709a-f for about 10 milliseconds. Accordingly, an inherent cooling capability of the stacks 709a-f is sufficient, since a time of the current transfer via the stacks 709a-f is extremely short. During a failure of one power semiconductor chip of one of the stacks of one power semiconductor module, the respective stack or power semiconductor is short circuited, as is described above in connection with Figures 1 to 4. Thus, a switching capability of the DC circuit breaker apparatus 712 is provided by the other power semiconductor modules electrically connected in series to the failed power semiconductor module.

According to another exemplary embodiment, all the issues mentioned above (particularly in the section "Background Art") are addressed in the presented invention. The invention here is on a concept of a power semiconductor module with internal SCFM capability without dry contacts and mechanical components developing high pressure and with double side cooling of chips in the power semiconductor module.

The proposed power semiconductor module basically consists of two electrically conductive plates between which the power semiconductor chips and, directly above or below the chips, additional elements are placed. The semiconductor chips and the additional elements form a stack. At least one stack is placed between the two electrically conductive baseplates. It is however preferred to place at least two stacks between the two baseplates. The additional elements are able to form a eutectic alloy together with silicon. To attach adjacent parts, joining methods such as soldering, brazing or sintering (etc.) are used. In an application the power semiconductor module is sandwiched between two coolers which also serve as positive and negative electrodes.

It has been shown experimentally that in such a structure, a SCFM is formed after a chip failure. The SCFM has been shown to possess a certain lifetime, at least several seconds. During this period, the failure (short circuit) could be detected and the control system could switch on a more reliable switch than a melted chip in the power semiconductor module. Such an approach could open the door for a new generation of considerably less expensive power semiconductor modules with SCFM capability; however, probably limited short circuit transition capability.

Summarizing, the advantages of the described package are: 1. Lower material and production cost than for a StakPak; 2. Higher switching power per silicon area due to the improved cooling; 3. Less package volume (in particular: less height) of the power semiconductor module; 4. High reliability under normal operation conditions (no dry contacts, CTE-matched materials, low chip temperature ripples due to large thermal masses directly attached to the chip); 5. SCFM capability.

Preferred embodiments may be as follows.

In a first embodiment (1. embodiment), the power semiconductor module includes a power semiconductor chip, a bottom electrically and thermally conductive electrode-baseplate, a top electrically and thermally conductive electrode-baseplate, a preform made of material supporting creation of spot in a case of a failure (creation of eutectic alloy with Si with lower melting temperature).

The bottom electrode of the power semiconductor chips is thermally and electrically connected to the bottom electrode-baseplate via a first bonding layer. The top electrode of the power semiconductor chip is thermally and electrically connected to the preform via a second bonding layer. The other side of the preform is thermally and electrically connected to the top electrode-baseplate via a third bonding layer.

An example of a small power semiconductor module based on this structure is shown in Figures 1 to 4.

In a second embodiment (2. embodiment), the power semiconductor module includes a power semiconductor chip, a bottom electrically and thermally conductive electrode-baseplate, a top electrically and thermally conductive electrode-baseplate, a first preform made of material supporting creation of spot in a case of a failure (creation of eutectic alloy with Si with lower melting temperature), a second preform made of material compensating CTE mismatch between a power semiconductor chip and the first preform.

The bottom electrode of the power semiconductor chips is thermally and electrically connected to the bottom electrode-baseplate via a first bonding layer. The top electrode of the power semiconductor chip is thermally and electrically connected to the first preform via a second bonding layer. The other side of the first preform is thermally and electrically connected to the second preform via a fourth bonding layer. The other side of the second preform is thermally and electrically connected to the top baseplate via a third bonding layer.

A schematic picture of such structure is shown in Figures 5 and 6.

Further embodiments of the power semiconductor module may be as follows.
A 3. embodiment may relate to a power semiconductor module as described in the 1. and/or 2. embodiment, wherein the bottom electrode of the power semiconductor chip is bonded to the bottom electrode-baseplate via a silver layer.
A 4. embodiment may relate to a power semiconductor module as described in the 1. and/or 2 embodiment, wherein the first preform is bonded to the top electrode of the power semiconductor chip via a silver layer.
A 5. embodiment may relate to a power semiconductor module as described in the 2 embodiment, wherein the second preform is bonded to the first preform via a silver layer.
A 6. embodiment may relate to a power semiconductor module as described in the 1. and/or 2. embodiment, wherein the top electrode is bonded to the first preform or the second preform via a layer of solder.
A 7. embodiment may relate to a power semiconductor device as described in one of the previous embodiments, wherein the power semiconductor chips are e.g. IGBTs, diodes, reverse conductive chips.
A 8. embodiment may relate to a power semiconductor module as described in one of the previous embodiments, wherein the baseplates could be made of Molybdenum, Al-graphite, Cu-graphite, Cu-molybdenum etc. (materials with CTE close enough to silicon).
A 9. embodiment may relate to a power semiconductor module as described in the 1 embodiment, wherein the first preform is made of e.g. Al-graphite.
A 10. embodiment may relate to a power semiconductor module as described in 1 embodiment, wherein the preform is made of laminate material (sandwich) - AI/Mo(AIMo)AI.
A 11. embodiment may relate to a power semiconductor module as described in the in 2. embodiment, wherein the first preform is made of Aluminium, Silver, Gold; The second preform is made of Algraphite, Cu-graphite, Cu-moly, Molybdenum (CTE = 3-8).
A 12. embodiment may relate to a power semiconductor module as described in 8. and/or 9. embodiment, wherein Al-graphite has an Aluminium skin increasing amount of Aluminium available for hot spot.
A 13. embodiment may relate to a power semiconductor device as described in the 1. and/or 2. embodiment, wherein there is Al foil between the bottom electrode-baseplate and the bottom electrode of the power semiconductor chip.
A 14. embodiment may relate to a power semiconductor module as described in the 13 embodiment, wherein there is a silver layer between the bottom electrode-baseplate and Al foil and there is another silver layer and between Al-layer and the power semiconductor chips - Al layer is bonded on bottom electrode-baseplate and the power semiconductor chips are bonded on Al layer.
A 15. embodiment may relate to a power semiconductor module as described in one of the previous embodiments, wherein the power semiconductor chips are embedded in silicone gel bringing sufficient electrical isolation.
A 16. embodiment may relate to a power semiconductor module as described in one of the previous embodiments, wherein the substrate for a gate connection, surface of components (e.g. gold plating etc) can be also defined in additional dependant claims.
A 17. embodiment may relate to a power semiconductor module as described in one of the previous embodiments, wherein the structure has a package-case withstanding the failure event and formation of the hot spot.
In a 18. embodiement (method), a subassembly - bottom electrode-baseplate, power semiconductor chip and preform is prepared by the silver sintering process (eventually also Al foil from 13) and the top electrode-baseplateof the power semiconductor module is bonded using soldering.
In a 19. embodiment (method), the subassembly - bottom electrode-baseplate, chip, first and second preform is prepared by the sintering process (eventually also Al foil from 13) and the top electrode-baseplate is bonded using soldering.
A 20. embodiment may relate to the method as described in the 18 or 19 embodiment, wherein sintering can be LTB (low-temperature bonding) or nanosintering.
A 21. embodiment may relate to the method as described in one of the embodiment 18 to 20, wherein all components can be sintered in one step using fixture.
A 22. embodiment may relate to the method as described in one of the embodiment 18 to 21, wherein the preforms can be sintered on the power semiconductor chips and afterwards the power semiconductor chips with preforms are sintered to the bottom electrode.
A 23. embodiment may relate to the method as described in one of the embodiment 19 to 22, wherein preforms are sintered together and than bonded to power semiconductor chip surface in the next sintering step (less contamination of chip edges).

Additional remarks regarding the embodiments may be as follows:

Sintered bonds should be sufficiently strong to withstand SC event.

The presspack module should be in principle able to handle a transition event.

The press-pack is very compact - this improves cooling of chips.

Double-side cooled power module with SCFM capability may be described.

A double-side cooled module of press-pack type with an internal short circuit failure mode capability is presented. Bonding technologies which only recently got more attention in power electronics in a combination with CTE (coefficient of thermal expansion) matched emitter or top electrode-baseplate and collector or bottom electrode-baseplates are proposed for its fabrication. This approach should allow fabrication of very compact and relatively simple power semiconductor modules without internal dry contacts suitable especially for multilevel converter topologies applied in a power transmission area.

In the following, reference between the above described first and second embodiments (and the further embodiments) and the Figures may be presented.

Figures 1 to 4 are showing an example of a small double side cooled power semiconductor module with SCFM capability according to the 1. embodiment. This power semiconductor module was designed with the aim to check feasibility of the concept. Figure 1: A bottom electrode-baseplate with bonded power semiconductor chips and first preforms supporting SCFM - hot spot formation. Materials of the first preform and power semiconductor chip form a eutectic alloy with a low-melting temperature. CTE of preform and power semiconductor chip is sufficiently close. Figure 2: A top electrode-baseplate was bonded to the top contact of the chip and/or the preform. Figure 3: The finalized power semiconductor module with a case. Figure 4: An example of a possible gate wiring of the power semiconductor module.

Figures 5, 6 may show a schematic cross-section and a detailed of a part of a power semiconductor module with SCFM capability according to the 2. embodiment. The collector side or bottom side of a power semiconductor chip is bonded to CTE reasonably matched bottom electrode-baseplate (e.g. Molybdenum) for example by sintering. The component or first preform made of metal suitable for SCFM capability (e.g. Aluminium) is sintered on the emitter or top side of the power semiconductor chip. In the same or the next sintering step another, second preform is bonded on the other side of the first preform. The second preform has CTE close to Silicon. In the final step the top electrode-baseplate is soldered to the second preform.

Another exemplary embodiment refers to a DC Circuit Breaker containing double-side cooled BIGT packages.

A background for this embodiment may be as follows.

DC Circuit Breakers containing IGBT and diodes as conducting / blocking elements show potential to be used in future HVDC transmission networks. Particularly promising properties are achievable using BIGT chips instead of the IGBT / diode combination since here, the health of the IGBTs and diodes can be monitored via the BIGT's gate.

For the DC circuit breaker proposed the capability of the BIGT power semiconductor module to fall into a short-circuit after e.g. a chip failure is required. However, the short-circuit mode does not need to possess a long lifetime since the power semiconductor chips are activated only for a short time during a switching event (total required short-circuit lifetime within 30 years: > 10 s).

A problem may be as follows.

Currently, StakPak packages are equipped with IGBT chips for operation in DC circuit breakers. However, these power semiconductor modules are overdesigned and bring in disadvantages for this application:

The StakPak construction is designed for a long short-circuit lifetime and is hence a complex and expensive construction. The cost of the StakPak power semiconductor modules significantly contributes to the whole DC circuit breaker cost.

In a StakPak, the power semiconductor chips are attached to a relatively low thermal mass (Moly base plate at the bottom side of the chips). This means that a transient heat load is not buffered optimally.

Furthermore, due to the low thermal mass attached to the power semiconductor chips, the maximum duration of a high current pulse (e.g. 8-10 kA) through the chips is limited.

The embodiment may be described as follows.

These disadvantages can be overcome by using double-side cooled BIGT packages in the DC circuit breaker. Such a double-side cooled power semiconductor module basically consists of one or several BIGT chips which are sandwiched between two electrically conductive plates - electrode-baseplates - to which the power semiconductor chips are attached. Besides the top and bottom electrode-baseplates, additional components (such as spacer layers) could be included.

Recent experiments have shown that when such a power semiconductor module has Al adjacent to the Si chips, an electrically conductive alloy is formed in the case of a failure, i.e. the package is short-circuited, as required by the application. However, the lifetime of this short-circuit mode is shorter than that of the StakPak but still fully sufficient to meet the requirements of DC circuit breakers (shortest measured short-circuit lifetime of a non-optimized package: several minutes). Hence, double-side cooled power semiconductor modules with such a short-term short-circuit capability can be used for this application.

To reduce the risk of a too short lifetime, the power semiconductor module can be combined with some other short-circuit functionality that could e.g. be triggered by the driving gate unit.

This invention combines several novel technologies (double-side cooled packages, BIGT chips, transistor-based DC circuit breaker) to obtain a substantial cost and/or performance improvement of DC circuit breakers.

A business benefit may be as follows.

1. The power semiconductor module itself is significantly cheaper than the StakPak due to its simple construction. Since the power semiconductor module represents a large amount of the total DC circuit breaker cost (> 50% (70%), depending what you include in the costs) the cost of the entire circuit breaker can be significantly reduced.

2. Compared to a StakPak, due to the improved thermal properties of double-side cooled power semiconductor module, the same performance (e.g. current carrying capability for a specified duration) can be obtained using a smaller number of power semiconductor chips (or modules). This further reduces cost.

3. In a double-side cooled power semiconductor module, two large thermal masses (e.g. two Moly plates) are directly attached to the two main surfaces of the power semiconductor chip by e.g. a soldered or sintered connection. Transient heat pulses in the chips will be more effectively buffered by the thermal capacitances of the plates in direct vicinity to the chips. Since the chips only generate heat for a very short time in a DC circuit breaker, an active cooling system (e.g. water cooling) can be designed less powerful - or might even become obsolete. This saves further cost.

4. The double-side cooled power semiconductor module are very flat compared to the StakPak (approx. 2/3 lower package height). If a large number of power semiconductor modules (e.g. 100) is connected in series, this lower package height saves a lot of space (several meters when summing up all the package heights) making the whole DC circuit breaker construction more compact.

An example of this embodiment may be shown in Figure 7.

### Reference signs list

- 102, 502: bottom electrode-baseplate
- 104a-f, 504a, b: power semiconductor chip
- 106a-f, 506a, b: first preform, preform
- 208, 508: top electrode-baseplate
- 209a-f, 509a, b, 709a-f: stacks
- 310: housing
- 311,611,711: silicone gel
- 312, 512, 712: power semiconductor module
- 413a-d: bonding wires
- 414a-c: gate contact
- 415: conductive lead
- 516a, b: second preform
- 618: first bonding layer
- 620: second bonding layer
- 622: third bonding layer
- 624: fourth bonding layer

## Claims

1. Power semiconductor module comprising:
- a bottom electrode-baseplate (102, 502), wherein the bottom electrode-baseplate (102, 502) is electrically and thermally conductive,
- a top electrode-baseplate (208, 508), wherein the top electrode-baseplate (208, 508) is electrically and thermally conductive,
- a power semiconductor chip (104a-f, 504a, b),
- and a first preform (106a-f, 506a, 506b), wherein
- the power semiconductor chip (104a-f, 504a, b) comprises a bottom electrode and a top electrode,
- the first preform (106a-f, 506a, b) is made of material configured for supporting a creation of an electrically conductive alloy when being melted, the first preform (106a-f, 506a, 506b) provides in combination with the power semiconductor chip (104a-f, 504a, 504b) a short circuit failure mode capability of the power semiconductor module, and
wherein the bottom electrode of the power semiconductor chip (104a-f, 504a, b) is thermally and electrically connected to the bottom electrode-baseplate (102, 502) via a first bonding layer (618), and wherein the top electrode of the power semiconductor chip (104a-f, 504a, b) is thermally and electrically connected to a first side of the first preform (106a-f, 506a, b) via a second bonding layer (620),
wherein
the second side of the first preform (106a-f, 506a, b) is thermally and electrically connected to the top electrode-baseplate (108, 508) via a third bonding layer (624), and wherein
the first and second bonding layers are sintered bonds **characterised in that** the third bonding layer (624) is configured as a layer of solder.

2. The power semiconductor module according to claim 1, **characterised in that** a thickness of the first preform (106a-f, 506a, 506b) is at least 50% of the thickness of the power semiconductor chip (104a-f) and/or has a thickness of at least 0.1mm, more preferable of at least 0.5mm and most preferably of at least 0.8mm.

3. The power semiconductor module according to claim 1 or 2, **characterised by** a stack (209a-f, 509a, 509b, 709a-f) comprising the semiconductor chip (104a-f, 504a, 504b) and the first preform (106a-f, 506a, 506b), and wherein a bonding layer is formed between all elements of the stack (209a-f, 509a, 509b, 709a-f), including the semiconductor chip (104a-f, 504a, 504b) and the first preform (106a-f, 506a, 506b), so that all elements of the stack (209a-f, 509a, 509b, 709a-f) are thermally and electrically connected to each other via the bonding layers and a bottom element of the stack (209a-f, 509a, 509b, 709a-f) being connected to the bottom electrode-baseplate (102, 502) by the first bonding layer (618) and the top element of the stack being connected to the top electrode-baseplate (108, 508) by the third bonding layer.

4. The power semiconductor module according to claim 3, **characterised in that** at least two stacks (209a-f, 509a, 509b, 709a-f) are arranged in parallel.

5. The power semiconductor module according to one of the claims 1 to 4, **characterised in that** the top electrode-baseplate (208, 508) is arranged in parallel to the bottom electrode-baseplate (102, 502).

6. The power semiconductor module (209a-f, 509a, b, 709a-f) according to one of the claims 1 to 5, further comprising:
- a second preform (516a, b) comprising material being configured for compensating a thermal expansion mismatch between the power semiconductor chip (104a-f, 504a, b) and the first preform (506a, b), wherein the second side of the first preform (506a, b) is thermally and electrically connected to a first side of the second preform (516a, b) via a fourth bonding layer (622), wherein the second side of the second preform (516a, b) is thermally and electrically connected to the top electrode-baseplate (508) via the third bonding layer (624).

7. The power semiconductor module (209a-f, 509a, b, 709a-f) according to one of the claim 1 to 6, wherein at least one of first and second bonding layers (618, 620) is configured as silver layers.

8. The power semiconductor module (509a, b) according to anyone of claims 6 to 7 wherein the fourth bonding layer (622) is configured as a silver layer.

9. The power semiconductor module (509a, b) according to anyone of claims 6 to 8 wherein the fourth bonding layer (622) is a sintered bond.

10. The power semiconductor module (209a-f, 509a, b, 709a-f) according to anyone of claims 1 to 9, wherein the power semiconductor chip (104a-f, 504a, b) comprises an insulated gate bipolar transistor, a diode, a metal oxide semiconductor field effect transistor, a thyristor, a gate turn off thyristor, an integrated gate commutated thyristor or a reverse conductive chip.

11. The power semiconductor module (209a-f) according to anyone of claims 1 to 5, 7 or 10 , wherein the first preform (106a-f) is made of aluminum-graphite or a laminate material of aluminum and molybdenum-aluminum.

12. The power semiconductor module (509a, b) according to anyone of claims 6-10 , wherein the first preform (506a, b) is made of aluminum, silver, gold, copper and/or magnesium, and wherein the second preform (516a, b) is made of aluminum-graphite, copper-graphite, copper-molybdenum or molybdenum.

13. The power semiconductor module (209a-f, 509a, b, 709a-f) according to anyone of claims 1 to 12, wherein an aluminum foil is arranged between the bottom electrode-baseplate (102, 502) and the bottom electrode of the power semiconductor chip (104a-f, 504a, b).

14. An electronic power apparatus (312, 512, 712) comprising a power semiconductor module according to anyone of the claims 1 to 13, wherein the electronic power apparatus (312, 512, 712) is configured as a direct current circuit breaker apparatus.

15. A method of manufacturing a power semiconductor device (209a-f, 509a, b, 709a-f), the method comprising:
- providing a power semiconductor chip (104a-f, 504a, b) comprising a bottom electrode and a top electrode;
- providing a bottom electrode-baseplate (102, 502), wherein the bottom electrode-baseplate (102, 502) is electrically and thermally conductive;
- providing a top electrode-baseplate (108, 508), wherein the top electrode-baseplate (108, 508) is electrically and thermally conductive;
- providing a first preform (106a-f, 506a, b) made of material configured for supporting a creation of an electrically conductive alloy when being melted;
- preparing a subassembly (517a, b) of the bottom electrode-baseplate (102, 502), the semiconductor chip (104a-f, 504a, b), and the first preform (106a-f, 506a, b) by stacking and bonding them together; and
- bonding the top electrode-baseplate (108, 508) to the subassembly (517a, b) **characterized in that**
- for preparing the subassembly a sintering process is used for bonding and for bonding the top electrode-baseplate to the subassembly soldering is used.

16. The method according to claim 15, the method further comprising:
- Providing a second preform (506a, b) made of material being configured for compensating a thermal expansion-mismatch between the semiconductor chip (504a, b) and the first preform (506a, b), and
- bonding the second preform (516a, b) to the subassembly (517a, b).

## Patentansprüche

1. Leistungshalbleitermodul, umfassend:
- eine untere Elektrodengrundplatte (102, 502), wobei die untere Elektrodengrundplatte (102, 502) elektrisch und thermisch leitend ist,
- eine obere Elektrodengrundplatte (208, 508), wobei die obere Elektrodengrundplatte (208, 508) elektrisch und thermisch leitend ist,
- einen Leistungshalbleiterchip (104a-f, 504a, b),
- und eine erste Löttablette (106a-f, 506a, 506b), wobei
- der Leistungshalbleiterchip (104a-f, 504a, b) eine untere Elektrode und eine obere Elektrode umfasst,
- die erste Löttablette (106a-f, 506a, b) aus Material besteht, das dafür ausgelegt ist, eine Bildung einer elektrisch leitenden Legierung zu unterstützen, wenn es geschmolzen wird, wobei die erste Löttablette (106a-f, 506a, 506b) in Kombination mit dem Leistungshalbleiterchip (104a-f, 504a, 504b) eine Kurzschlussausfallmodusfähigkeit des Leistungshalbleitermoduls bereitstellt, und
wobei die untere Elektrode des Leistungshalbleiterchips (104a-f, 504a, b) über eine erste Bondschicht (618) thermisch und elektrisch mit der unteren Elektrodengrundplatte (102, 502) verbunden ist, und wobei die obere Elektrode des Leistungshalbleiterchips (104a-f, 504a, b) über eine zweite Bondschicht (620) thermisch und elektrisch mit einer ersten Seite der ersten Löttablette (106a-f, 506a, b) verbunden ist, wobei die zweite Seite der ersten Löttablette (106a-f, 506a, b) über eine dritte Bondschicht (624) thermisch und elektrisch mit der oberen Elektrodengrundplatte (108, 508) verbunden ist, und wobei
es sich bei der ersten und der zweiten Bondschicht um Sinterbonds handelt, **dadurch gekennzeichnet, dass** die dritte Bondschicht (624) als eine Schicht aus Lot ausgelegt ist.

2. Leistungshalbleitermodul nach Anspruch 1, **dadurch gekennzeichnet, dass** eine Dicke der ersten Löttablette (106a-f, 506a, 506b) mindestens 50 % der Dicke des Leistungshalbleiterchips (104a-f) beträgt und/oder eine Dicke von mindestens 0,1 mm, bevorzugter von mindestens 0,5 mm und am meisten bevorzugt von mindestens 0,8 mm aufweist.

3. Leistungshalbleitermodul nach Anspruch 1 oder 2, **gekennzeichnet durch** einen Stapel (209a-f, 509a, 509b, 709a-f), der den Halbleiterchip (104a-f, 504a, 504b) und die erste Löttablette (106a-f, 506a, 506b) umfasst, und wobei eine Bondschicht zwischen allen Elementen des Stapels (209a-f, 509a, 509b, 709a-f) einschließlich des Halbleiterchips (104a-f, 504a, 504b) und der ersten Löttablette (106a-f, 506a, 506b) ausgebildet ist, so dass alle Elemente des Stapels (209a-f, 509a, 509b, 709a-f) über die Bondschichten thermisch und elektrisch miteinander verbunden sind und ein unteres Element des Stapels (209a-f, 509a, 509b, 709a-f) durch die erste Bondschicht (618) mit der unteren Elektrodengrundplatte (102, 502) verbunden ist und das obere Element des Stapels durch die dritte Bondschicht mit der oberen Elektrodengrundplatte (108, 508) verbunden ist.

4. Leistungshalbleitermodul nach Anspruch 3, **dadurch gekennzeichnet, dass** mindestens zwei Stapel (209a-f, 509a, 509b, 709a-f) parallel angeordnet sind.

5. Leistungshalbleitermodul nach einem der Ansprüche 1 bis 4, **dadurch gekennzeichnet, dass** die obere Elektrodengrundplatte (208, 508) parallel zur unteren Elektrodengrundplatte (102, 502) angeordnet ist.

6. Leistungshalbleitermodul (209a-f, 509a, b, 709a-f) nach einem der Ansprüche 1 bis 5, ferner umfassend:
- eine zweite Löttablette (516a, b), umfassend Material, das zum Kompensieren einer Wärmeausdehnungsfehlanpassung zwischen dem Leistungshalbleiterchip (104a-f, 504a, b) und der ersten Löttablette (506a, b) ausgelegt ist, wobei die zweite Seite der ersten Löttablette (506a, b) über eine vierte Bondschicht (622) thermisch und elektrisch mit einer ersten Seite der zweiten Löttablette (516a, b) verbunden ist, wobei die zweite Seite der zweiten Löttablette (516a, b) über die dritte Bondschicht (624) thermisch und elektrisch mit der oberen Elektrodengrundplatte (508) verbunden ist.

7. Leistungshalbleitermodul (209a-f, 509a, b, 709a-f) nach einem der Ansprüche 1 bis 6, wobei mindestens eine von der ersten und der zweiten Bondschicht (618, 620) als Silberschicht ausgelegt ist.

8. Leistungshalbleitermodul (509a, b) nach einem der Ansprüche 6 bis 7, wobei die vierte Bondschicht (622) als Silberschicht ausgelegt ist.

9. Leistungshalbleitermodul (509a, b) nach einem der Ansprüche 6 bis 8, wobei die vierte Bondschicht (622) ein Sinterbond ist.

10. Leistungshalbleitermodul (209a-f, 509a, b, 709a-f) nach einem der Ansprüche 1 bis 9, wobei der Leistungshalbleiterchip (104a-f, 504a, b) einen Bipolartransistor mit isoliertem Gate, eine Diode, einen Metalloxid-Halbleiter-Feldeffekttransistor, einen Thyristor, einen "Gate Turn-Off Thyristor", einen "Integrated Gate Commutated Thyristor" oder einen rückwärts leitenden Chip umfasst.

11. Leistungshalbleitermodul (209a-f) nach einem der Ansprüche 1 bis 5, 7 oder 10, wobei die erste Löttablette (106a-f) aus Aluminium-Graphit oder einem Laminatmaterial aus Aluminium und Molybdän-Aluminium besteht.

12. Leistungshalbleitermodul (509a, b) nach einem der Ansprüche 6 bis 10, wobei die erste Löttablette (506a, b) aus Aluminium, Silber, Gold, Kupfer und/oder Magnesium besteht und wobei die zweite Löttablette (516a, b) aus Aluminium-Graphit, Kupfer-Graphit, Kupfer-Molybdän oder Molybdän besteht.

13. Leistungshalbleitermodul (209a-f, 509a, b, 709a-f) nach einem der Ansprüche 1 bis 12, wobei zwischen der unteren Elektrodengrundplatte (102, 502) und der unteren Elektrode des Leistungshalbleiterchips (104a-f, 504a, b) eine Aluminiumfolie angeordnet ist.

14. Leistungselektronische Vorrichtung (312, 512, 712), umfassend ein Leistungshalbleitermodul nach einem der Ansprüche 1 bis 13, wobei die leistungselektronische Vorrichtung (312, 512, 712) als eine Gleichstromunterbrechungsvorrichtung ausgelegt ist.

15. Verfahren zur Herstellung einer Leistungshalbleitervorrichtung (209a-f, 509a, b, 709a-f), wobei das Verfahren umfasst:
- Bereitstellen eines Leistungshalbleiterchips (104a-f, 504a, b), umfassend eine untere Elektrode und eine obere Elektrode;
- Bereitstellen einer unteren Elektrodengrundplatte (102, 502), wobei die untere Elektrodengrundplatte (102, 502) elektrisch und thermisch leitend ist,
- Bereitstellen einer oberen Elektrodengrundplatte (108, 508), wobei die obere Elektrodengrundplatte (108, 508) elektrisch und thermisch leitend ist,
- Bereitstellen einer ersten Löttablette (106a-f, 506a, b), die aus Material besteht, das dafür ausgelegt ist, eine Bildung einer elektrisch leitenden Legierung zu unterstützen, wenn es geschmolzen wird;
- Vorbereiten einer Teilanordnung (517a, b) aus der unteren Elektrodengrundplatte (102, 502), dem Halbleiterchip (104a-f, 504a, b) und der ersten Löttablette (106a-f, 506a, b) durch Stapeln und aneinander Bonden; und
- Bonden der oberen Elektrodengrundplatte (108, 508) mit der Teilanordnung (517a, b), **dadurch gekennzeichnet, dass**
- zum Vorbereiten der Teilanordnung ein Sinterverfahren zum Bonden verwendet wird und zum Bonden der oberen Elektrodengrundplatte mit der Teilanordnung Löten verwendet wird.

16. Verfahren nach Anspruch 15, wobei das Verfahren ferner umfasst:
- Bereitstellen einer zweiten Löttablette (506a, b), die aus Material besteht, das zum Kompensieren einer Wärmeausdehnungsfehlanpassung zwischen dem Halbleiterchip (504a, b) und der ersten Löttablette (506a, b) ausgelegt ist, und
- Bonden der zweiten Löttablette (516a, b) mit der Teilanordnung (517a, b).

## Revendications

1. Module semi-conducteur de puissance comprenant :
- une plaque de base pour électrode inférieure (102, 502), la plaque de base pour électrode inférieure (102, 502) étant électriquement et thermiquement conductrice,
- une plaque de base pour électrode supérieure (208, 508), la plaque de base pour électrode supérieure (208, 508) étant électriquement et thermiquement conductrice,
- une puce semi-conductrice de puissance (104a-f, 504a, b),
- et une première préforme (106a-f, 506a, 506b), dans lequel
- la puce semi-conductrice de puissance (104a-f, 504a, b) comprend une électrode inférieure et une électrode supérieure,
- la première préforme (106a-f, 506a, b) est constituée d'un matériau configuré pour supporter la création d'un alliage électriquement conducteur lorsqu'il est fondu, la première préforme (106a-f, 506a, 506b) fournit, en combinaison avec la puce semi-conductrice de puissance (104a-f, 504a, 504b), une capacité de mode de défaillance par court-circuit du module semi-conducteur de puissance, et
dans lequel l'électrode inférieure de la puce semi-conductrice de puissance (104a-f, 504a, b) est reliée thermiquement et électriquement à la plaque de base pour électrode inférieure (102, 502) par le biais d'une première couche de liaison (618), et dans lequel l'électrode supérieure de la puce semi-conductrice de puissance (104a-f, 504a, b) est reliée thermiquement et électriquement à un premier côté de la première préforme (106a-f, 506a, b) par le biais d'une deuxième couche de liaison (620),
dans lequel
le deuxième côté de la première préforme (106a-f, 506a, b) est relié thermiquement et électriquement à la plaque de base pour électrode supérieure (108, 508) par le biais d'une troisième couche de liaison (624), et dans lequel
les première et deuxième couches de liaison sont des liaisons frittées, **caractérisé en ce que** la troisième couche de liaison (624) est configurée comme une couche de brasure.

2. Module semi-conducteur de puissance selon la revendication 1, **caractérisé en ce qu'**une épaisseur de la première préforme (106a-f, 506a, 506b) représente au moins 50 % de l'épaisseur de la puce conductrice de puissance (104a-f) et/ou a une épaisseur d'au moins 0,1 mm, mieux encore d'au moins 0,5 mm et idéalement d'au moins 0,8 mm.

3. Module semi-conducteur de puissance selon la revendication 1 ou 2, **caractérisé par** un empilement (209a-f, 509a, 509b, 709a-f) comprenant la puce semi-conductrice (104a-f, 504a, 504b) et la première préforme (106a-f, 506a, 506b), et dans lequel une couche de liaison est formée entre tous les éléments de l'empilement (209a-f, 509a, 509b, 709a-f) comportant la puce semi-conductrice (104a-f, 504a, 504b) et la première préforme (106a-f, 506a, 506b), de sorte que tous les éléments de l'empilement (209a-f, 509a, 509b, 709a-f) sont reliés thermiquement et électriquement les uns aux autres par le biais des couches de liaison et un élément inférieur de l'empilement (209a-f, 509a, 509b, 709a-f) est relié à la plaque de base pour électrode inférieure (102, 502) par la première couche de liaison (618) et l'élément supérieur de l'empilement est relié à la plaque de base pour électrode supérieure (108, 508) par la troisième couche de liaison.

4. Module semi-conducteur de puissance selon la revendication 3, **caractérisé en ce qu'**au moins deux empilements (209a-f, 509a, 509b, 709a-f) sont disposés en parallèle.

5. Module semi-conducteur de puissance selon une des revendications 1 à 4, **caractérisé en ce que** la plaque de base pour électrode supérieure (208, 508) est disposée parallèlement à la plaque de base pour électrode inférieure (102, 502).

6. Module semi-conducteur de puissance (209a-f, 509a, b, 709a-f) selon une des revendications 1 à 5, comprenant en outre :
- une deuxième préforme (516a, b) comprenant un matériau configuré pour compenser une différence de dilatation thermique entre la puce semi-conductrice de puissance (104a-f, 504a, b) et la première préforme (506a, b), le deuxième côté de la première préforme (506a, b) étant relié thermiquement et électriquement à un premier côté de la deuxième préforme (516a, b) par le biais d'une quatrième couche de liaison (622), le deuxième côté de la deuxième préforme (516a, b) étant relié thermiquement et électriquement à la plaque de base pour électrode supérieure (508) par le biais de la troisième couche de liaison (624).

7. Module semi-conducteur de puissance (209a-f, 509a, b, 709a-f) selon une des revendications 1 à 6, dans lequel au moins une des première et deuxième couches de liaison (618, 620) est configurée comme une couche d'argent.

8. Module semi-conducteur de puissance (509a, b) selon l'une quelconque des revendications 6 à 7 dans lequel la quatrième couche de liaison (622) est configurée comme une couche d'argent.

9. Module semi-conducteur de puissance (509a, b) selon l'une quelconque des revendications 6 à 8 dans lequel la quatrième couche de liaison (622) est une liaison frittée.

10. Module semi-conducteur de puissance (209a-f, 509a, b, 709a-f) selon l'une quelconque des revendications 1 à 9, dans lequel la puce semi-conductrice de puissance (104a-f, 504a, b) comprend un transistor bipolaire à grille isolée, une diode, un transistor à effet de champ à métal-oxyde-semi-conducteur, un thyristor, un thyristor interrupteur, un thyristor commuté à grille intégrée ou une puce à conduction inverse.

11. Module semi-conducteur de puissance (209a-f) selon l'une quelconque des revendications 1 à 5, 7 ou 10, dans lequel la première préforme (106a-f) est constituée d'aluminium-graphite ou d'un matériau stratifié d'aluminium et de molybdène-aluminium.

12. Module semi-conducteur de puissance (509a, b) selon l'une quelconque des revendications 6 à 10, dans lequel la première préforme (506a, b) est constituée d'aluminium, d'argent, d'or, de cuivre et/ou de magnésium, et dans lequel la deuxième préforme (516a, b) est constituée d'aluminium-graphite, de cuivre-graphite, de cuivre-molybdène ou de molybdène.

13. Module semi-conducteur de puissance (209a-f, 509a, b, 709a-f) selon l'une quelconque des revendications 1 à 12, dans lequel une feuille d'aluminium est disposée entre la plaque de base pour électrode inférieure (102, 502) et l'électrode inférieure de la puce conductrice de puissance (104a-f, 504a, b).

14. Appareil électronique de puissance (312, 512, 712) comprenant un module semi-conducteur de puissance selon l'une quelconque des revendications 1 à 13, l'appareil électronique de puissance (312, 512, 712) étant configuré comme un appareil disjoncteur à courant continu.

15. Procédé de fabrication d'un dispositif semi-conducteur de puissance (209a-f, 509a, b, 709a-f), le procédé comprenant :
- l'obtention d'une puce semi-conductrice de puissance (104a-f, 504a, b) comprenant une électrode inférieure et une électrode supérieure ;
- l'obtention d'une plaque de base pour électrode inférieure (102, 502), la plaque de base pour électrode inférieure (102, 502) étant électriquement et thermiquement conductrice ;
- l'obtention d'une plaque de base pour électrode supérieure (108, 508), la plaque de base pour électrode supérieure (108, 508) étant électriquement et thermiquement conductrice ;
- l'obtention d'une première préforme (106a-f, 506a, b) constituée d'un matériau configuré pour supporter la création d'un alliage électriquement conducteur lorsqu'il est fondu ;
- la préparation d'un sous-ensemble (517a, b) de la plaque de base pour électrode inférieure (102, 502), la puce semi-conductrice (104a-f, 504a, b) et la première préforme (106a-f, 506a, b) par empilement et liaison de celles-ci ; et
- la liaison de la plaque de base pour électrode supérieure (108, 508) au sous-ensemble (517a, b), **caractérisé en ce que**
- pour la préparation du sous-ensemble, un procédé de frittage est utilisé pour la liaison, et pour lier la plaque de base pour électrode supérieure au sous-ensemble, un brasage est utilisé.

16. Procédé selon la revendication 15, le procédé comprenant en outre :
- l'obtention d'une deuxième préforme (506a, b) constituée d'un matériau configuré pour compenser une différence de dilatation thermique entre la puce semi-conductrice (504a, b) et la première préforme (506a, b), et
- la liaison de la deuxième préforme (516a, b) au sous-ensemble (517a, b).
